# DEMANDE DE BREVET EUROPEEN

(11) **EP 3 771 007 A1**
(43) Date de publication de la demande: **27.01.2021**
(21) Numéro de dépôt: 20186652.2
(22) Date de dépôt: 20.07.2020
(51) Int. Cl.: H01M 6/40, H01L 21/56, B29C 33/40, H01M 2/20, H01M 10/04, H01M 10/0585, H01M 2/10, H01M 10/052, H01L 23/28, B29C 45/32

(54) **MOULE D'ASSEMBLAGE POUR FABRIQUER UN DISPOTITIF TRIDIMENSIONNEL COMPRENANT PLUSIEURS COMPOSANTS MICROELECTRONIQUES ET PROCÉDÉ D'UTILISATION DUDIT MOULE**

(30) Priorité: 24.07.2019 FR 1908400
(71) Demandeur: Commissariat à l'énergie atomique et aux énergies alternatives, 75015 Paris (FR)
(72) Inventeur: BEDJAOUI, Messaoud, 38054 GRENOBLE CEDEX 09 (FR); BRUN, Jean, 38054 GRENOBLE CEDEX 09 (FR); POULET, Sylvain, 38054 GRENOBLE CEDEX 09 (FR)
(74) Mandataire: Brevalex

(57) **Abrégé**

Moule d'assemblage (500), réutilisable, pour fabriquer un dispositif tridimensionnel comprenant plusieurs composants microélectroniques (300) empilés verticalement, comprenant une cavité principale (501), formée d'un fond et d'une paroi latérale, et configurée pour recevoir au moins deux structures élémentaires empilées, chaque structure élémentaire comprenant un substrat (200) fragile recouvert par un composant microélectronique (300) et par des contacts électriques (210), disposés sur le bord du substrat, le moule d'assemblage (500) étant en un matériau déformable pouvant subir une déformation réversible de 10 à 1000% par rapport à sa forme initiale, préférentiellement de 50 à 200% par rapport à sa forme initiale,
le moule d'assemblage (500) comprenant en outre un dégagement (510) positionné le long de la paroi latérale de la cavité principale (501) pour faciliter la manipulation de la première structure élémentaire et/ou de la deuxième structure élémentaire et/ou pour injecter un élément le long de la cavité principale (501).

## Description

### DOMAINE TECHNIQUE

La présente invention se rapporte au domaine général de l'assemblage vertical, de l'encapsulation et de l'interconnexion électrique de composants microélectroniques et plus particulièrement des microbatteries au lithium.

L'invention concerne un moule pour fabriquer un dispositif tridimensionnel comprenant plusieurs composants microélectroniques empilés verticalement.

L'invention concerne également un procédé de fabrication d'un tel dispositif tridimensionnel.

L'invention est particulièrement intéressante puisqu'elle propose un procédé permettant d'assembler verticalement et précisément plusieurs composants microélectroniques, disposés sur substrats ultrafins. Au-delà des bonnes performances électrochimiques des assemblages réalisés, on obtient une encapsulation complète des composants microélectroniques tout en offrant une facilité d'interconnexion électrique de ces composants électriques. De plus, l'invention est compatible avec les étapes d'intégration avec des circuits microélectroniques externes.

L'invention trouve des applications dans de nombreux domaines industriels, et notamment dans le domaine de l'énergie et des systèmes autonomes multifonctionnels.

### ÉTAT DE LA TECHNIQUE ANTÉRIEURE

Ces dernières années ont vu l'essor des objets connectés (ou loT pour « Internet of Things »). Ces objets nécessitent parfois d'être associés à des dispositifs microélectroniques pour la récupération et le stockage d'énergie. De tels dispositifs doivent répondre à de nombreuses contraintes technologiques, pour pouvoir être utilisés avec ces objets connectés, comme de bonnes performances électriques, un dimensionnel très conformable et un encombrement réduit. Notamment, dans le cas des microbatteries, il est nécessaire d'avoir des microbatteries présentant de bonnes performances électrochimiques et de très fortes capacités volumiques, c'est-à-dire un rapport entre la capacité surfacique et le volume du composant élevé.

Pour optimiser les performances électrochimiques des microbatteries, il existe plusieurs leviers : la forme et les dimensions (« design ») des couches actives, la nature des matériaux d'électrodes employés, les procédés de fabrication et les techniques d'emballage (« packaging »).

L'optimisation de la capacité volumique des microbatteries est atteignable en réduisant l'encombrement des couches dites passives, notamment l'encombrement de la couche d'encapsulation et des couches d'interconnexion, par rapport aux couches dites actives, comme les électrodes.

L'une des solutions de l'état de l'art consiste à empiler plusieurs composants unitaires afin de répondre favorablement à ces problématiques, comme décrit dans les documents US 2017/0111994 A1 et US 2009/0136839 A1. L'interconnexion électrique entre les microbatteries unitaires est obtenue en remplissant, par des colles conductrices, des vias traversant formés à chaque coin du substrat hôte. L'inconvénient majeur de ces solutions réside dans la création de zones fragiles à l'extrémité des composants (les coins). Cet inconvénient est très prononcé pour des substrats dits ultrafins (ayant une épaisseur inférieure à 100µm, voire inférieure à 50µm) ayant une surface dont les dimensions sont millimétriques.

### EXPOSÉ DE L'INVENTION

Un but de la présente invention est de proposer un procédé de fabrication d'un dispositif tridimensionnel comprenant plusieurs composants microélectroniques empilés verticalement, ayant une forte capacité volumique et une bonne tenue mécanique, même pour des substrats ultra-fins, permettant d'empiler facilement et précisément les composants microélectroniques et de réaliser facilement l'interconnexion électrique de ces composants.

Pour cela, la présente invention propose un moule d'assemblage, réutilisable, pour fabriquer un dispositif tridimensionnel comprenant plusieurs composants microélectroniques empilés verticalement, comprenant une cavité principale, formée d'un fond et d'une paroi latérale, et configurée pour recevoir au moins deux structures élémentaires empilées (i.e. au moins une première structure élémentaire et une deuxième structure élémentaire empilées), chaque structure élémentaire comprenant un substrat fragile recouvert par un composant microélectronique et par des contacts électriques, disposés sur le bord du substrat, le moule d'assemblage étant en un matériau déformable pouvant subir une déformation réversible de 10 à 1000% par rapport à sa forme initiale, préférentiellement de 50 à 200% par rapport à sa forme initiale.

Le moule d'assemblage comprend en outre un dégagement positionné le long de la paroi latérale pour faciliter la manipulation de la première structure élémentaire et/ou de la deuxième structure élémentaire et/ou pour injecter un élément le long de la cavité. Ceci particulièrement avantageux pour former des contacts électriques le long des structures élémentaires.

Par fragile, on entend un substrat fin ou ultra-fin, i.e. ayant une épaisseur inférieure à 100µm et préférentiellement inférieure à 50µm.

Le moule d'assemblage est un support compartimenté. La cavité principale du moule est utilisée pour le positionnement et l'encadrement des structures élémentaires à empiler. Le fond du moule présente la même forme et les mêmes dimensions que le substrat des structures élémentaires de manière à pouvoir empiler précisément les structures élémentaires et à aligner verticalement leurs contacts électriques.

Avec un tel moule, les composants microélectroniques sont facilement empilés les uns sur les autres sans avoir besoin de faire appel aux techniques de positionnement et d'alignement de l'état de l'art.

Les structures élémentaires, disposées, dans la cavité principale du moule peuvent facilement être électriquement connectées en parallèle ou bien en série, sur les bords du substrat, sans avoir besoin de former des vias dans les substrats des structures élémentaires. Plus de deux structures élémentaires (par exemple de 4 à 7 structures élémentaires) peuvent être positionnées dans la cavité principale.

Le moule est un matériau étirable, pouvant être déformé, ce qui facilite le positionnement des structures élémentaires et/ou le retrait de l'assemblage final. Il est réutilisable.

Avantageusement, le moule est un matériau polymère, de préférence, du polysiloxane. De tels moules sont simples, rapides et peu coûteux à fabriquer. On choisira, de préférence, du polydiméthylsiloxane (PDMS). La flexibilité et la mobilité de la chaîne polymère du matériau PDMS entraînent après durcissement une excellente élasticité et une bonne résistance au déchirement autorisant des mouvements multiples de compression et d'extension. Les moules d'assemblage en PDMS peuvent avoir une déformabilité avec une élongation de 120% et une résistance à la traction de l'ordre de 7,1 MPa. L'exploitation de cette propriété d'élasticité facilite l'étape de démoulage.

Avantageusement, le fond de la cavité principale a une forme carrée.

Avantageusement, le moule d'assemblage comprend une cavité additionnelle, en connexion fluidique avec la cavité principale, formant un réservoir, permettant notamment d'injecter une colle électriquement isolante.

L'invention concerne également un procédé de fabrication d'un dispositif tridimensionnel comprenant plusieurs composants microélectroniques empilés verticalement, le procédé comprenant les étapes suivantes :
a) fournir une première structure élémentaire et une deuxième structure élémentaire, chaque structure élémentaire comprenant un substrat ayant une première face principale et une deuxième face principale, la première face principale du substrat étant recouverte par un composant microélectronique, et par des contacts électriques, disposés sur les bords du substrat, et électriquement connectés au composant microélectronique,
b) fournir un moule d'assemblage tel que défini précédemment, comprenant une cavité principale, formée d'un fond et d'une paroi latérale, et configurée pour recevoir au moins deux structures élémentaires, le moule d'assemblage étant en un matériau déformable pouvant subir une déformation réversible de 10 à 1000% par rapport à sa forme initiale, préférentiellement de 50 à 200% par rapport à sa forme initiale,
c) disposer la première structure élémentaire dans la cavité principale du moule d'assemblage,
d) former une couche de colle électriquement isolante entre la première structure élémentaire et la deuxième structure élémentaire,
e) disposer la deuxième structure élémentaire dans la cavité principale du moule d'assemblage,
f) connecter électriquement les contacts électriques de la première structure élémentaire et de la deuxième structure élémentaire,
moyennant quoi on forme un dispositif tridimensionnel présentant une bonne tenue mécanique et dont les composants microélectroniques sont électriquement connectés au niveau des bords des substrats des structures élémentaires.

Le procédé se distingue fondamentalement des procédés de l'art antérieur par la mise en œuvre du moule d'assemblage décrit précédemment. Les avantages liés au moule d'assemblage se retrouvent pour le procédé.

Avantageusement, les étapes d), e) et f) sont réalisées dans l'ordre suivant : e), d) puis f), ou e), f) puis d). En particulier, la mise en œuvre des étapes e), f) et d) est intéressante s'il y a deux dégagements le long de la cavité (un pour former les contacts électriques et un pour injecter la colle isolante).

Avantageusement, le moule d'assemblage comprend une cavité additionnelle, en connexion fluidique avec la cavité principale, formant des réservoirs, et la couche de colle électriquement isolante est formée en injectant entre les structures élémentaires la colle électriquement isolante à partir de la cavité additionnelle.

La solidarisation mécanique des structures élémentaires les unes aux autres est réalisée grâce à la colle électriquement isolante.

Avantageusement, le moule d'assemblage comprend au moins un dégagement, positionné le long de la paroi latérale de la cavité principale, au niveau des contacts électriques des structures élémentaires et l'étape f) est réalisée en remplissant le dégagement d'un élément électriquement conducteur moyennant quoi on connecte électriquement les contacts électriques des deux structures élémentaires.

Avec un tel procédé, il n'y a pas besoin de réaliser des vias dans les substrats des structures élémentaires. Les contacts électriques de l'ensemble des structures élémentaires sont reliés, par exemple, par des techniques de dispense de colles électriquement conductrices. L'interconnexion électrique des structures élémentaires se fait, avantageusement, le long de la paroi latérale des substrats des structures élémentaires, et non pas au travers comme les procédés de l'art antérieur.

La réalisation des étapes d'interconnexion électrique et de solidarisation mécanique en deux étapes distinctes évite les problèmes d'incompatibilité chimique à l'état liquide entre les colles, qui peuvent détériorer les propriétés de conduction électrique des colles conductrices. En effet, dans le cas de colle électriquement conductrice contenant des inclusions métalliques, celles-ci peuvent se retrouver noyées dans une matrice électriquement isolante plus importante, ce qui affecte les propriétés de conduction électriques obtenue par percolation des inclusions métalliques.

L'aménagement des compartiments (dégagement et réservoir) permet de mieux canaliser le flux et le surplus des colles utilisées.

Le procédé d'assemblage est simple à mettre en œuvre. Les composants microélectroniques, et notamment les couches lithiées des microbatteries, des structures élémentaires sont encapsulés efficacement grâce à ce procédé d'intégration.

Avantageusement, le moule est en polysiloxane, et de préférence en PDMS. Ces matériaux présentent des propriétés d'aversion vis-à-vis des colles électriquement isolantes et conductrices, dues à l'incompatibilité des chaînes du polymère avec des surfaces ou des produits hydrophiles. L'assemblage final est facile à retirer du moule d'assemblage.

Ce procédé est facile à mettre en œuvre par rapport aux procédés selon l'art antérieur qui nécessitent des équipements de manipulation des composants relativement complexes et/ou coûteux pour réaliser des empilements verticaux.

Le moule d'assemblage nécessaire à la mise en œuvre du procédé selon l'invention, est un élément bon marché, simple à fabriquer et simple à utiliser.

Un dispositif tridimensionnel, obtenu par le procédé précédemment décrit, comprend une première structure élémentaire et une deuxième structure élémentaire, formant un empilement vertical, chaque structure élémentaire comprenant un substrat recouvert par un composant microélectronique et par des contacts électriques électriquement connectés au composant microélectronique, une couche de colle électriquement isolante étant disposée entre la première structure élémentaire et la deuxième structure élémentaire, et une couche électriquement conductrice connectant électriquement les contacts électriques de la première structure élémentaire et de la deuxième structure élémentaire, le long de l'empilement vertical.

Un tel dispositif peut comprendre de 4 à 7 structures élémentaires empilées verticalement.

Le dispositif obtenu présente une bonne tenue mécanique.

Dans le dispositif, l'interconnexion électrique entre les différents étages est assurée par la continuité des points de colle conductrice entre les différents niveaux des contacts électriques de chaque structure élémentaire. De ce fait, les connexions électriques se situent sur les flancs du module assemblé et non pas à travers les substrats. La reprise de contact peut donc se faire sur les flancs du module ou bien sur la surface du premier ou du dernier composant constituant l'empilement.

Dans ce dispositif, l'encombrement des couches dites passives, notamment la couche d'encapsulation et les couches d'interconnexion est réduit : la capacité volumique (définie par le rapport entre la capacité surfacique et le volume du composant microélectronique) est améliorée.

Grâce à la miniaturisation et la compacité du dispositif contenant les composants microélectroniques, ce dernier est particulièrement intéressant pour des applications dans le domaine de la récupération d'énergie. Le dispositif peut comprendre plusieurs composants microélectroniques identiques ou différents, par exemple des microbatteries interconnectées avec d'autres dispositifs microélectroniques (tels que des systèmes électro-chromes ou des cellules photovoltaïques), pour réaliser des systèmes autonomes multifonctionnels.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 représente, de manière schématique et en coupe, une microbatterie, selon un mode de réalisation particulier de l'invention,
La figure 2 représente, de manière schématique et en vue de dessous, la face avant du substrat d'une microbatterie ainsi que des contacts anodiques et cathodiques, selon un mode de réalisation particulier de l'invention,
La figure 3 représente, de manière schématique et en coupe, un support rigide microstructuré, selon un mode de réalisation particulier de l'invention,
La figure. 4 représente, de manière schématique et en vue de dessus, un support rigide microstructuré, selon un mode de réalisation particulier de l'invention,
La figure 5 représente, de manière schématique et en vue de dessus, un moule d'assemblage, selon un mode de réalisation particulier de l'invention,
La figure 6 est un cliché photographique d'un moule d'assemblage en matériau polymère, selon un mode de réalisation particulier de l'invention,
Les figures 7a, 7b, 8, 9, 10 et 11 représentent de manière schématique différentes étapes du procédé de fabrication d'un assemblage de composants microélectroniques empilés verticalement, selon différents modes de réalisation de l'invention,
La figure 12 représente des clichés réalisés par microscopie en tomographie d'un assemblage vertical obtenu selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », «dessous », etc. d'une structure s'appliquent en considérant que la structure est orientée de la façon illustrée sur les figures.

### EXPOSÉ DÉTAILLÉ DE MODES DE RÉALISATION PARTICULIERS

Par la suite, même si la description fait référence à des microbatteries, et plus particulièrement à des microbatteries au lithium, le procédé peut être appliqué pour l'encapsulation et l'assemblage vertical d'autres composants microélectroniques.

Bien que cela ne soit aucunement limitatif, l'invention trouve particulièrement des applications dans le domaine de l'énergie et pour la fabrication de systèmes autonomes multifonctionnels ayant une forte capacité volumique.

Le procédé de fabrication d'un dispositif tridimensionnel comprenant un empilement vertical de microbatteries comprend les étapes suivantes :
- fabrication des microbatteries 300,
- fabrication du moule d'assemblage 500 à partir d'un support 400 rigide et structuré,
- positionnement des microbatteries 300 dans le moule d'assemblage 500,
- formation des reprises de contact 320,
- encapsulation des microbatteries et renforcement mécanique du module de microbatteries avec une couche électriquement isolante 330,
- séparation du module de microbatteries du moule d'assemblage 500.

### Etape 1 : Fabrication des microbatteries 300 sur un substrat 200 :

### Substrat 200 :

Le substrat 200, aussi appelé substrat hôte ou substrat support est fin ou ultra-fin, i.e. il a une épaisseur inférieure à 100µm et préférentiellement inférieure à 50µm. De telles épaisseurs permettent de répondre aux exigences d'augmentation de la capacité volumique.

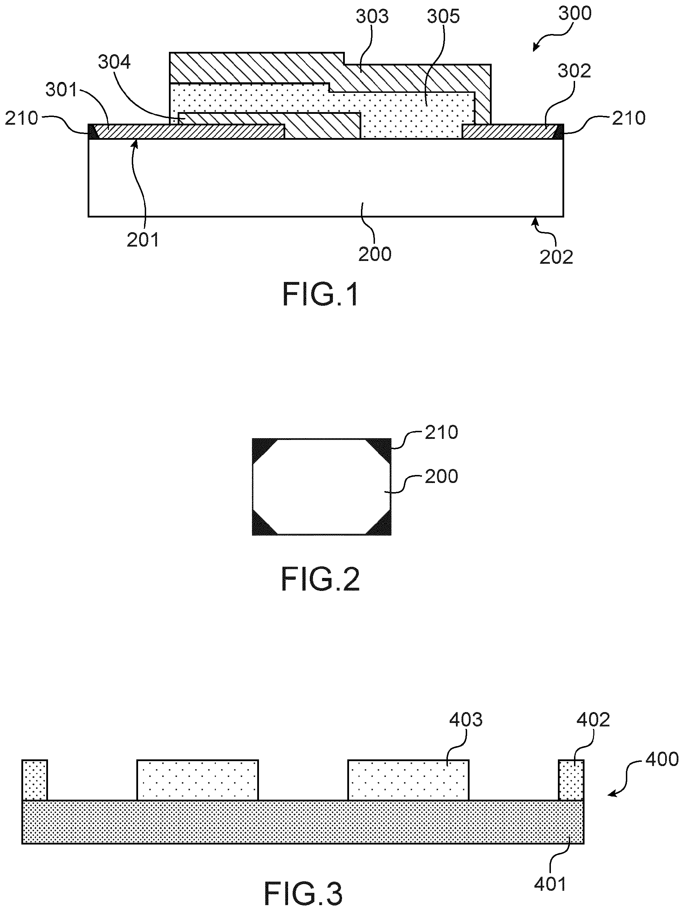

Comme représenté sur la figure 1, le substrat 200 comporte une première face principale 201, dite face active (ou face avant), opposée à une seconde face principale 202 (dite face arrière). Le substrat 200 comprend également une face latérale allant de la première face principale 201 à la seconde face principale.

Le substrat 200 peut avoir différentes formes géométriques. Il est possible par exemple d'utiliser des formats circulaires type wafers ou des formats feuilles, c'est-à-dire rectangulaires.

Le substrat a, avantageusement, les performances requises pour l'encapsulation des microbatteries au lithium. Il est élaboré en un matériau ayant des niveaux de barrière WVTR (« Water Vapor Transmission Rate ») et OTR (« Oxygen Transmission Rate ») au plus, respectivement, de 10⁻⁴ g/m²/j et de
10⁻⁴ cm³/m²/j pour garantir des propriétés d'étanchéité suffisantes vis-à-vis de l'air et de la vapeur d'eau.

Le substrat 200 peut être en un matériau choisi parmi les verres, le silicium (monocristallin ou polycristallin), les céramiques, le mica, et le quartz.

De préférence, il est en verre. De tels substrats sont compatibles avec les procédés d'amincissement par rectification mécanique (« grinding »), malgré la présence d'une forte topographie induite par l'empilement des couches actives des microbatteries.

Les verres peuvent être des borosilicates (comme les D263®LA, D263®M, D263®T, MEMpax® ou encore le Borofloat® commercialisés par la société SCHOTT®), des dérivés de borosilicates comme les verres alkali-free borosilicates (AF32®, AF45, Corning®Willow....) ou encore des verres de type boro-aluminosilicates (« alkaline earth boro-aluminosilcates ») commercialisés par exemple par les sociétés Corning Lotus™, EAGLE XG®. De tels substrats sont parfaitement adaptés aux procédés de fabrication des microbatteries au lithium.

De préférence, le substrat 200 est transparent aux longueurs d'onde des lasers classiquement utilisés pour les étapes de découpe. Par transparent, on entend que le substrat 200 laisse passer au moins 50% de la lumière émise par le laser.

### Dispositif microélectronique 300 :

Au moins un dispositif microélectronique 300 est disposé sur la première face principale 201 du substrat 200 (face active). Le dispositif microélectronique a une épaisseur allant de 5µm à 30µm, et de préférence de 10 à 15µm.

Par exemple, les dimensions externes du dispositif microélectronique sont de 4mmx4mm.

La première face 201 du substrat 200 peut comporter plusieurs dispositifs microélectroniques 300 afin, par exemple, de multiplier les performances électrochimiques par une mise en parallèle ou en série des dispositifs microélectroniques. Les dispositifs microélectroniques 300 peuvent être identiques ou différents.

Par dispositif microélectronique, on entend un composant microélectronique 300, comme par exemple, un MEMS (microsystème électromécanique), un MOEMS (microsystème opto-électro-mécanique), un micro-détecteur infrarouge, un transistor, une microbatterie, une capacité, une supra-capacité, un composant photovoltaïque, une antenne ou tout autre dispositif jugé nécessaire pour la réalisation d'objets connectés.

Par la suite, même si la description fait référence à une microbatterie par structure élémentaire, et plus particulièrement à une microbatterie au lithium, l'invention est transposable à tout dispositif microélectronique 300, éventuellement sensible à l'air (au dioxygène et à la vapeur d'eau). Il peut s'agir, par exemple d'un empilement capacitif ou d'un composant électrochrome.

L'invention est également transposable à un groupe de dispositifs microélectroniques par structure élémentaire.

Comme représenté sur la figure 1, la microbatterie 300 comprend des collecteurs de courant cathodique 301 et anodique 302, disposés sur le substrat 200.

Les collecteurs de courant 301, 302 sont, avantageusement, métalliques. A titre illustratif, ils peuvent être en titane, or, aluminium, platine, ou en tungstène. Ils ont, par exemple, une épaisseur de 300nm.

Les collecteurs de courant 301, 302 sont reliés électriquement à des reprises de contact électriques 210 disposées sur le substrat 200, et plus particulièrement sur le bord du substrat (figure 2). Les reprises de contact sont ainsi directement accessibles depuis la face latérale du substrat.

Il y a une reprise de contact dite anodique et une reprise de contact dite cathodique.

Les reprises de contact peuvent être sur la première face 201 ou sur la seconde face 202 du substrat 200. La plus grande dimension de la reprise 210 peut être de quelques centaines de micromètres.

Selon une autre variante de réalisation, les collecteurs de courant 301, 302 forment les reprises de contact 210.

Deux couches actives, l'une formant l'électrode négative 303, et l'autre formant l'électrode positive 304, sont séparées par une couche d'électrolyte 305. Chaque couche active 303, 304 est en contact avec l'un des collecteurs de courant 301, 302.

L'électrode positive 304 (cathode) est en un matériau ayant une bonne conductivité électronique et ionique (par exemple TiOS, TiS₂, LiTiOS, LiTiS₂, LiCoO₂, V₂O₅...). On choisira de préférence une électrode positive en oxyde de cobalt. Ce type de cathode est considéré comme l'une des couches les plus performantes pour les microbatteries et en même temps les plus contraintes lors des étapes de réalisation. En effet, les contraintes mécaniques engendrées après formation de la couche cathodique (Coefficient d'expansion thermique entre 10x10⁻⁶/°C et 15x10⁻⁶/°C et un module de Young entre 100 et 500 GPa) peuvent influer sur le comportement des substrats rigides une fois amincis.

L'électrolyte 305 est un isolant électronique avec une forte conductivité ionique (par exemple LiPON, LiPONB, LiSiCON...).

L'électrode négative 303 (anode) est une couche qui peut être du lithium métallique ou un matériau lithié.

Optionnellement et selon les configurations, les couches actives peuvent être protégées par un système d'encapsulation primaire composé d'une ou de plusieurs couches barrières élémentaires dont le rôle principal est de garantir une intégrité des dispositifs microbatteries pendant les différentes phases du procédé.

La microbatterie sera réalisée par les techniques connues de l'homme du métier.

### Etape 2 : Fabrication du support 400 rigide et structuré destiné à fabriquer le moule d'assemblage 500 :

Cette étape est indépendante de l'étape de fabrication des microbatteries (étape 1). Elle peut être réalisée préalablement ou ultérieurement à l'étape 1.

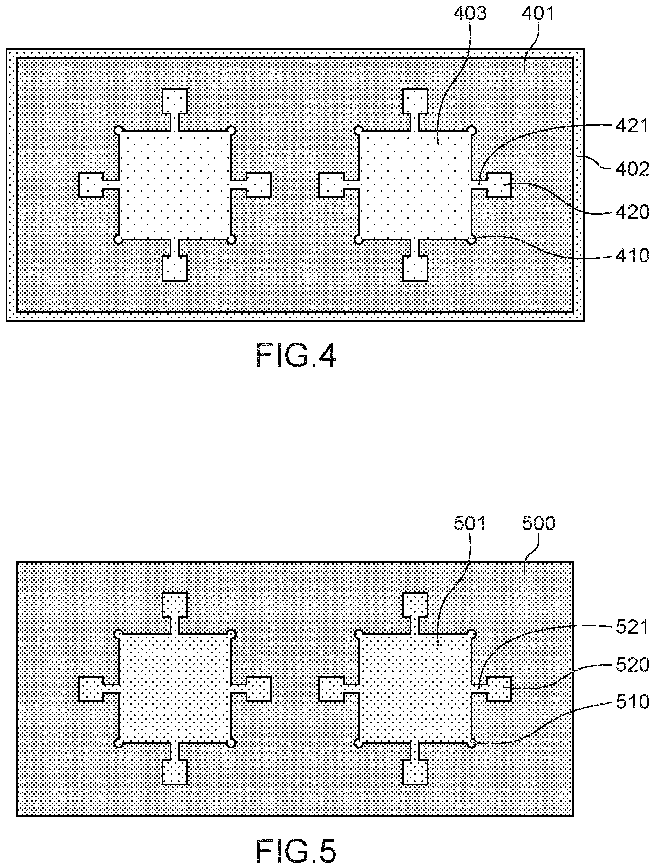

Le support 400 structuré, représenté sur les figures 3 et 4, est en un matériau plastique rigide.

Le support 400 est en un matériau dont la température de fusion est supérieure à celle du moule. Autrement dit, le matériau de support doit être compatible avec les procédés de durcissement du matériau polymère du moule. Par exemple, on choisira un matériau ayant une résistance à des températures supérieures à 200°C.

On choisira, de préférence, le matériau parmi un métal, une céramique, un polymère, un matériau diélectrique ou un de leurs mélanges. D'une manière générale, tout matériau ou tout mélange de matériaux permettant de créer les zones compartimentées peuvent être utilisés.

À titre illustratif, il peut s'agir d'un matériau choisi parmi le PVC, le PMMA, le silicium, le quartz, le verre...

De préférence, le support 400 est en polytétrafluoroéthylène (PTFE) commercialisé sous la référence Téflon®.

Le support 400 présente une partie plane 401 recouverte par des parties en saillie 403 formant une ou plusieurs zones en surépaisseur par rapport à la partie plane 401. Le support comprend en périphérie un bord 402 en surépaisseur. La valeur de la surépaisseur, définissant par la suite la profondeur du moule, est fixée en fonction du nombre de structures élémentaires à empiler. A titre d'exemple, une surépaisseur de 400µm permet l'empilement de 5 structures élémentaires.

Le support 400 peut être fabriqué par exemple par des techniques d'usinage mécanique, usinage laser, usinage physique, ou encore par gravure chimique.

Selon une autre alternative, il peut être thermoformé.

Selon une autre alternative, le support 400 peut être obtenu en solidarisant différents éléments 402, 403 sur un support plan 401 de manière à créer des zones en relief. Selon ce mode de réalisation, la base plane 401 du support 400 et les éléments en relief 402, 403 peuvent être en des matériaux identiques ou différents.

Le support 400 peut avoir une épaisseur de 3mm à 10mm, par exemple 5mm.

Selon un mode de réalisation particulièrement avantageux et représenté sur la figure 4, des zones complémentaires 410, 420, 421 peuvent être apportées au design du support. Les zones complémentaires sont notamment des zones pleines dans le support et donc seront des zones évidées dans le moule. Par exemple, les zones complémentaires peuvent permettre de définir des dégagements, des microcavités jouant le rôle de réservoirs de taille micrométrique (microréservoir) connectées à des canaux d'écoulement permettant d'injecter un élément liquide ou un élément visqueux telle qu'une colle ou encore de récupérer le surplus de colle résultant du procédé d'assemblage.

On choisira une structuration et/ou une texturation du support 400 permettant de fabriquer facilement le moule 400, en particulier permettant l'écoulement d'un polymère à l'état liquide.

En fonction de la technique d'usinage du support 400, l'imprécision des dimensions peut être limitée à quelques microns.

### Etape 3 : Fabrication du moule d'assemblage :

La fabrication du moule d'assemblage 500 est obtenue en créant une réplique dite 'négative' du support 400 (figure 5).

Le moule 500 est, de préférence, en un matériau élastomère. On choisira, avantageusement, un polymère organique.

Le procédé de fabrication du moule d'assemblage 500 comprend, de préférence, les étapes suivantes :
- remplissage du support 400 rigide et structuré avec un polymère à l'état liquide,
- solidification du polymère moyennant quoi on forme un moule 500 en polymère.

Selon un mode de réalisation particulièrement avantageux, le polymère à l'état liquide est mélangé avec un agent réticulant avant d'être versé sur le support 400 structuré. L'ensemble est ensuite chauffé pour former le moule 500 après réticulation thermique. Puis l'ensemble est refroidi jusqu'à la température ambiante (typiquement de 20 à 25°C).

L'étape de solidification (aussi appelée étape de durcissement) permet de façonner un moule 500 solide en un matériau polymère contenant des compartiments pour loger les composants unitaires.

Alternativement, l'étape de solidification peut être réalisée à température ambiante, en choisissant un temps d'attente suffisant pour conduire à la solidification du moule polymérique.

Le moule est ensuite démoulé du support.

On choisira, avantageusement, un polymère répondant à un ou plusieurs des critères suivants : aversion vis-à-vis des colles, flexibilité, tenue en température de préférence jusqu'à 150°C et de préférence jusqu'à 200°C.

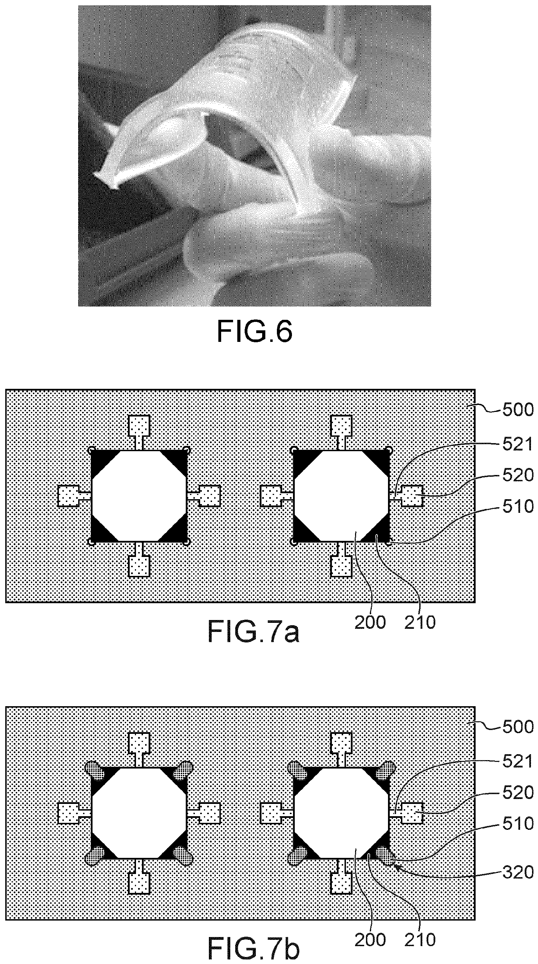

Le moule en matériau polymère, une fois solidifié et/ou réticulé est déformable (figure 6). Par matériau déformable, on entend un matériau pouvant subir une déformation réversible de 10 à 1000% par rapport à sa forme initiale, préférentiellement de 50 à 200% par rapport à sa forme initiale. Par déformation réversible, on entend que, après déformation, il reprend sa forme initiale.

Avantageusement, le polymère est un polysiloxane. Il a, par exemple, une viscosité inférieure à 20 Pa.S à l'état liquide. Ici, et par la suite, les valeurs de viscosité sont données à 25°C. Ce matériau est souple, déformable et très peu sensible aux variations de la température. L'allongement en rupture peut dépasser les 100% voire atteindre des valeurs de l'ordre de 1000% tandis que la résistance à la traction peut varier de 0,1MPa jusqu'à 20MPa.

A titre d'exemple, dans la famille des polysiloxanes, on pourra choisir le polydiméthylsiloxane (noté PDMS et parfois appelé diméthicole) qui est un polymère organominéral (i.e. une structure contenant du carbone et du silicium). Typiquement, le PDMS à l'état liquide est défini par une viscosité de l'ordre de 5 Pa.S à l'état liquide. Après réticulation, le moule en PDMS présente une élongation de 120%, une résistance à la traction de l'ordre de 7.1 MPa et une résistance thermique jusqu'à 200°C. Avantageusement, le PDMS épouse parfaitement le masque du support sans coller de façon irréversible au support.

A titre illustratif et non limitatif, le moule 400 compartimenté est fabriqué à partir du produit commercialisé par Dow Corning sous la référence Sylgard184.

Le moule 400 peut également être fabriqué à partir du produit commercialisé sous la référence Ecoflex® par Smooth-On. Ces polymères présentent une très bonne élasticité (élongation avant rupture qui avoisine une valeur de 1000% et une résistance à la traction inférieure à 2 MPa) et sont très stables dans une gamme de température allant de -53°C à 232°C. A titre d'exemple, on peut citer le produit commercialisé sous la référence Ecoflex®00-30 ayant une viscosité de 3 Pa.S. La mise en forme de cet élastomère sera, avantageusement, suivie d'un premier recuit pendant 4 heures à 23°C et d'un second recuit à 80°C pendant 2h. Le moule obtenu présente une élongation de l'ordre de 900% et une résistance à la température jusqu'à 232°C, ce qui permet l'utilisation de colles isolantes et conductrices pour l'assemblage des microbatteries unitaires dont la température de mise en œuvre est supérieure à 200°C et inférieure à 232°C.

Selon une variante avantageuse, le moule 500 peut également être en polyimide, par exemple en Kapton®.

Le moule 500 comprend une ou plusieurs cavités principales 501 pouvant être de formes et de tailles identiques ou différentes selon les dimensions et le nombre de structures élémentaires à empiler (figure 5). Les dimensions des cavités principales 501 dans le moule 500 correspondent, avantageusement, aux dimensions externes des structures élémentaires à assembler.

Chaque cavité 501 comprend un fond et une paroi latérale.

Avantageusement, la ou les cavités principales 501 comprennent un ou plusieurs dégagements 510. Ces dégagements 510 permettent de maîtriser le flux de colle, lors de l'assemblage. Ceci est particulièrement avantageux puisque la formation de couche de colle supplémentaire et non désirée à l'extérieur des composants assemblés peut diminuer les performances électrochimiques du dispositif et/ou créer des court-circuits. De plus, les dégagements 510 facilitent également la manipulation des structures élémentaires.

Notamment, dans le cas d'une cavité principale 501 dont le fond est de forme carrée, la présence de dégagement 510 au niveau des quatre coins de la cavité principale 501 de forme carrée facilitera le positionnement des substrats 200 des structures élémentaires dans le moule d'assemblage 500. En particulier, ces trous 510 facilitent la manipulation et le positionnement des substrats 200 très fins (typiquement d'une épaisseur inférieure à 100µm) de forme carrée, qui présentent une fragilité au niveau des coins.

### Etape 4: Positionnement des microbatteries 300 dans le moule d'assemblage 500 :

L'alignement des microbatteries 300 est facilité par la totale correspondance géométrique entre la cavité principale 501 du moule et les substrats des structures élémentaires à empiler (figure 7a). Typiquement la précision de positionnement des composants 300 dans les moules peut varier de façon globale entre 20 et 200µm selon la technique d'usinage des supports (mécanique, laser, chimique). Avantageusement, elle est inférieure à 50µm.

Cette étape permet d'obtenir un assemblage tridimensionnel de microbatteries 300. On entend par assemblage tridimensionnel, un empilement de plusieurs microbatteries unitaires superposées verticalement.

Par la suite, nous allons décrire la mise en parallèle de cinq microbatteries unitaires identiques, de forme carrée. Il est tout à fait possible d'assembler un autre nombre de composants unitaires ayant une forme carrée ou une autre forme en adaptant les dimensions géométriques du moule d'assemblage.

Pour cela, on positionne les structures élémentaires comprenant les microbatteries dans les cavités principales 501 (figures 7-a et 7b), c'est-à-dire avec la face avant 201 du substrat 200 dirigée vers le haut de manière à avoir la face arrière 202 du substrat 200 en regard du fond de la cavité et, avantageusement, pour rendre accessible les contacts électriques 210.

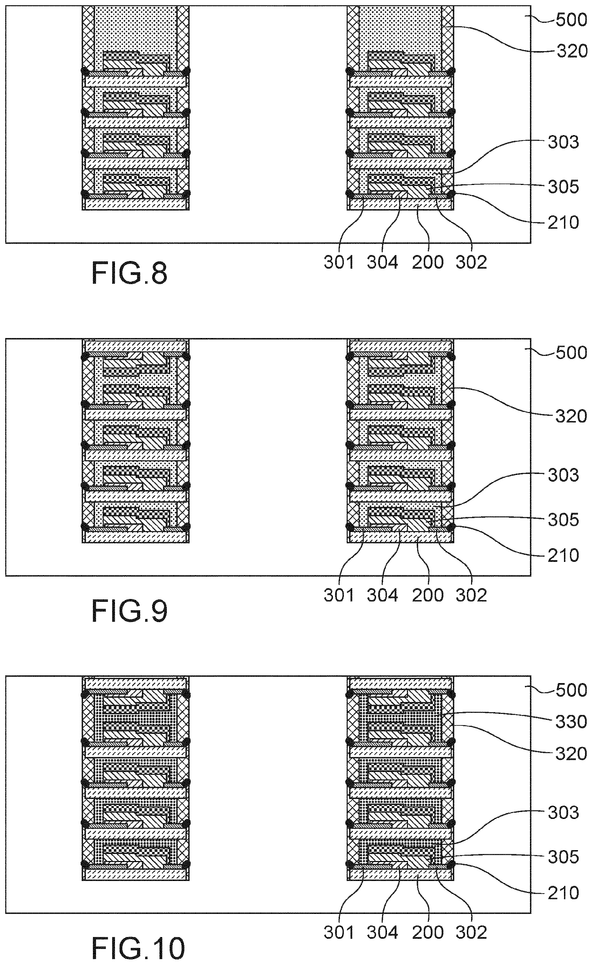

Les différents composants sont positionnés dans les cavités principales 501 du moule 500 et alignés entre eux avec une grande précision (figure 8).

Les composants unitaires sont manipulables de façon manuelle ou à l'aide d'une machine.

Les composants unitaires épousent parfaitement la forme des cavités principales 501 par un simple ajustement géométrique sans avoir recours à des techniques complexes et/ou couteuses.

De façon préférentielle, la cinquième et dernière structure élémentaire est positionnée dans une configuration dite tête bêche, permettant d'avoir les collecteurs métalliques de la microbatterie en regard des collecteurs métalliques de la microbatterie de structure élémentaire sous-jacente tout en respectant une mise en parallèle (figure 9). Une telle configuration offre une encapsulation complète du module de microbatteries assemblées, par la présence de deux substrats 200 étanches à la vapeur d'eau et aux oxydants de part et d'autre du module de microbatteries. Ainsi, les différentes couches actives sont enfermées entre le substrat de la première structure élémentaire et le substrat de la dernière structure élémentaire de l'empilement.

Dans une variante de réalisation, les microbatteries sont électriquement connectées en série. Cette mise en série peut être réalisée par contact direct entre les collecteurs cathodiques et les collecteurs anodiques. Contrairement à la mise en parallèle, ce mode de réalisation permet un ajustement de la tension de sortie du module de microbatterie.

Selon l'application visée, l'interconnexion de plusieurs batteries unitaires permet de moduler la puissance électrique du système obtenu par augmentation de la tension de sortie (on parle donc d'une mise en série) et/ou de la capacité de décharge (on parle d'une mise en parallèle). Il est possible aussi d'envisager plusieurs configurations (en série et en parallèle) au sein d'un même moule.

### Etape 5 : Connexion électrique des microbatteries :

En particulier, au cours de cette étape d'assemblage, on relie électriquement les différents contacts anodiques d'un côté et les contacts cathodiques de l'autre côté afin de respecter la disposition d'un mode de mise en parallèle.

L'opération de positionnement/alignement d'une structure élémentaire est suivie par la dispense d'une colle ou pâte électriquement conductrice 320 au niveau des contacts électriques 210 (figure 7b et 8).

Alternativement, il est possible de dispenser la colle électriquement conductrice 320 avant le positionnement de la structure élémentaire.

Les opérations de positionnement des structures élémentaires et de dispense de colle conductrice 320 sont répétées pour quatre des éléments unitaires de l'assemblage (figure 8).

La colle peut être déposée par sérigraphie par exemple.

Avantageusement, le surplus éventuel de colle conductrice 320 est accumulé au niveau des dégagements 510 ayant facilité la manipulation des substrats.

Le durcissement de la colle conductrice 320 se fait après le positionnement de toutes les microbatteries unitaires. Par exemple, il peut être réalisé en chauffant l'assemblage à une température de 80°C à 180°C, de préférence sous air.

Optionnellement, un appui mécanique est appliqué pendant le recuit thermique de la colle conductrice 320 pour un meilleur étalement des points de colle. Typiquement, l'épaisseur de la colle conductrice après l'étape de réticulation est de 20µm et le point de colle présente une résistivité volumique de 0,0004 Ω.cm.

Les plots de colle conductrice 320 ainsi formés aux quatre coins des microbatteries (figure 9) forment des zones de reprise de contact du module de microbatteries fabriqué, permettant une possible intégration avec des circuits externes. La forme des plots de colle peut être régulière (carrée, circulaire, elliptique, triangulaire) ou bien aléatoire.

La colle est, par exemple, une colle époxy contenant des particules électriquement conductrices, comme des particules métalliques. Par exemple, il s'agit de la colle commercialisée sous la référence Epo-Tek H20E par Epoxy Technology. De telles colles ont une résistivité volumique inférieure à 4x10⁻⁴ ohm.cm.

Nous pouvons également citer les références suivantes : Ablebond 84-1LMISR4, Hysol QMI516E commercialisées par Henkel ou SMDLTLFP15T4 commercialisée par Chipquik.

Il est possible d'utiliser des colles de type mono-composante ou bi-composante.

Selon un mode de réalisation particulier, la robustesse et la qualité des contacts électriques sont renforcés par un élément électriquement conducteur. Par exemple, il est possible d'ajouter des tiges métalliques au niveau des contacts électriques. Les tiges métalliques sont, par exemple, en cuivre. Les tiges métalliques peuvent avoir un diamètre de 50µm. Pour former un tel renfort, les tiges peuvent être plantées dans le moule d'assemblage 500 au niveau des dégagements 510 en amont du procédé d'assemblage. Ces tiges métalliques sont donc solidaires du moule. Elles se retrouvent fixées dans la colle électriquement conductrice au fur et à mesure du positionnement des microbatteries unitaires. La hauteur des tiges métalliques peut être rabotée en fin du procédé d'assemblage pour coïncider avec la hauteur du module de microbatteries. Avantageusement, la présence de ces tiges métalliques autorise l'emploi des techniques standards d'intégration des dispositifs microélectroniques par des technologies de soudure.

### Etape 6 : Renforcement mécanique du module de microbatteries :

Au cours de cette étape, la tenue mécanique du module de microbatteries est renforcée.

Pour cela, une colle électriquement isolante 330 est insérée dans l'espace inter-batteries, de préférence, à partir des réservoirs de stockage 520 et par l'intermédiaire les canaux 521 (figure 10).

L'espacement entre les différents niveaux des batteries est comblé par des colles isolantes 330 permettant ainsi de renforcer la robustesse mécanique du module de batteries tout en garantissant une séparation physique.

On choisira une colle électriquement isolante pouvant remplir par capillarité les espaces vides entre chaque étage de batterie. Il peut s'agir d'une colle époxy. A titre d'exemple non limitatif, on peut citer les colles bi-composantes commercialisées par Epoxy Technology sous la référence Epo-Tek 301-2 et 353ND. Un mélange massique des deux composantes de cette référence selon les proportions 100 pour 35 permet d'avoir des produits dotés d'une viscosité de 0,3 Pa.S. La colle Loctite Eccobond E1216M commercialisée par Henkel peut également être utilisée. On pourra également choisir les colles commercialisées par Henkel comme Ablebond 8387BM ou bien Hysol QMI536.

Un recuit sous air est ensuite avantageusement réalisé.

Selon une autre variante de réalisation, on réalise une seule étape de durcissement par recuit thermique pour réticuler la colle électriquement conductrice et la colle électriquement isolante de façon simultanée. A titre d'exemple, on choisira les couples de colle conductrice/colle isolante commercialisés par la société Henkel : Ablebond 84-1LMISR4/Ablebond 8387BM (recuit pendant 1 heure à 175°C) ou bien Hysol QMI516E/Hysol QMI536 (recuit 1h à 150°C).

De façon générale, les conditions de durcissement des colles électriquement isolantes et/ou conductrices peuvent être monitorées dans une gamme de température de 80°C à 180°C pour des durées d'une minute à une heure.

Le volume de colle isolante stockée dans les réservoirs 520 est, avantageusement, calibré en fonction de la quantité nécessaire pour occuper l'espace inter-batteries laissé libre par l'empilement des microbatteries (figure 10). Par exemple, le volume de colle isolante estimé pour garantir une répartition homogène d'une couche de 20µm entre des batteries d'une taille de 4mmx4mm est de l'ordre de 0,0013ml.

L'opération de remplissage des espaces vacants entre les batteries unitaires peut être répétée autant de fois que nécessaire. Les réservoirs 520 dédiés peuvent être remplis au cours du procédé pour régénérer le stock de colle isolante 330.

Au-delà du rôle principal de leurs rôles principaux (collage et conduction ou isolation électrique), les colles contribuent au renforcement de l'étanchéité du module obtenu, et notamment des microbatteries à base de matériaux lithiés, vis-à-vis des éléments atmosphériques tels que l'oxygène, l'azote et la vapeur d'eau.

La présence des colles électriquement isolantes permet, avantageusement, d'atteindre des niveaux d'étanchéité compris entre 10⁻⁴ et 10⁻⁶ g.m⁻².j⁻¹ pour le critère de transmission de la vapeur d'eau (ou WVTR pour « Water Vapor Transmission Rate ») et entre 10⁻⁴ et 10⁻⁶ cm⁻³.m⁻².j⁻¹ pour le critère de transmission de l'oxygène (ou OTR pour « Oxygen Transmission Rate »).

Les étapes 5 et 6 pourront être réalisées consécutivement selon les étapes suivantes : formation des contacts électrique 320 et recuit, puis dépôt de la colle électriquement isolante 330 et recuit.

Selon une variante de réalisation, il est possible d'intervertir l'ordre des étapes 5 et 6 : dépôt de la colle électriquement isolante 330 et recuit, puis formation des contacts électriques 320 et recuit.

Avantageusement, la séparation des étapes d'application de la colle conductrice 320 et la colle isolante 330 vise à s'affranchir d'éventuelles incompatibilités chimiques entre ces deux colles. On choisira, notamment, une colle isolante (dite « underfill ») en fonction de sa capillarité.

Selon une autre variante de réalisation, les étapes 5 et 6 sont réalisées simultanément selon les étapes suivantes : dépôt de la colle électriquement isolante 330 et formation des contacts électrique 320, puis recuit. Dans ce cas de figure, une précaution particulière doit être de mise dans le choix des colles conductrices et isolantes afin d'éviter tout phénomène d'incompatibilité qui peut induire une dégradation des propriétés de conduction électrique.

Selon une autre variante de réalisation, l'interconnexion électrique est réalisée après le dépôt et le recuit de la couche électriquement isolante 330 et une fois que le dispositif est sorti du moule d'assemblage. La colle électriquement isolante solidarise l'assemblage et facilite sa manipulation lors de l'interconnexion électrique.

Les profils de recuit peuvent toutefois être modifiés en fonction de la nature du moule, des contacts électriquement conducteurs et de la colle électriquement isolante. Optionnellement, une force mécanique est appliquée en amont du traitement thermique afin d'homogénéiser l'étalement des colles isolantes et conductrices entre les différents étages constituant le module microbatterie. Cela peut engendrer le débordement d'une portion des colles sous l'effet de la pression mécanique. Les colles en excès sont, avantageusement, évacuées vers le ou les microréservoirs 520 du moule d'assemblage 500 en périphérie de la cavité principale 501 logeant les microbatteries.

### Etape 7 : Séparation des microbatteries 300 assemblées du moule d'assemblage 500 :

L'étape de démoulage permet d'isoler le module microbatterie du moule d'assemblage.

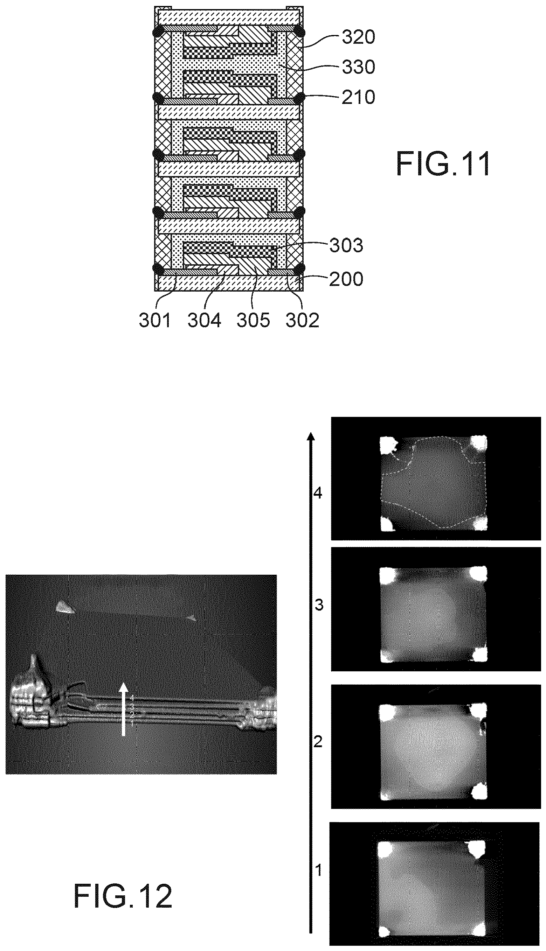

Cette étape de séparation est rendue possible grâce aux propriétés d'aversion et de déformabilité du moule d'assemblage 500. Le démoulage du module de microbatteries est, de préférence, réalisé par décollement. À l'issue de cette étape, on a séparé le module de microbatteries de son moule d'assemblage 500 (figure 11).

Le démoulage peut être réalisé de façon manuelle ou avec un outillage spécifique. Par exemple, le démoulage peut être réalisé par une ou plusieurs opérations mécaniques répétitives de contraction et de décontraction des moules. Les mouvements caractéristiques du procédé de démoulage sont possibles grâce aux propriétés d'élasticité et de déformation des matériaux élastomères en compression et en extension. L'exploitation de ces propriétés autorise de ce fait une libération aisée des modules tout en préservant l'intégrité des moules.

L'assemblage obtenu à l'issu du procédé peut être utilisé dans un dispositif ayant une simple encapsulation en couches minces (typiquement une couche d'encapsulation ayant une épaisseur inférieure à 10µm) puisque les différentes colles permettent ainsi de garantir, in fine, un niveau d'étanchéité très poussé.

Avantageusement, les moules 500 ne sont pas détériorés à l'issue du procédé, et peuvent être recyclés pour une nouvelle utilisation, ce qui réduit le coût des opérations d'assemblage.

### Exemples illustratifs et non limitatifs d'un mode de réalisation :

Dans cet exemple, les composants microélectroniques 300 sont des microbatteries. L'électrode positive est une couche LiCoO₂ d'une épaisseur de 20µm recuite à 600°C pendant 10h pour une bonne cristallisation du matériau LiCoO₂. L'électrolyte 305 est du LiPON de 3µm d'épaisseur. L'électrode négative 303 est une couche de silicium de 50nm.

Les collecteurs de courant cathodique et anodique sont sous la forme d'un triangle isocèle dont les côtés de même longueur mesurent 200µm.

Le support 400 est en PTFE. Il a une épaisseur de 5mm. Des zones évidées de 400µm de profondeur, par rapport à la base du support, ont été obtenues par évidement de matière du support 400, par fraisage. Les zones pleines 403 ont une forme carrée d'une superficie de 4,05mmx4,05mm.

Le moule d'assemblage 500 est en PDMS (Sylgard 184) d'une viscosité de 3,5 Pa.s commercialisé par la société Dow Corning. L'élastomère PDMS, sous forme liquide, est versé sur le support 400 afin de remplir les zones vides. Une fois le matériau PDMS durci à une température de 150°C pendant 10 minutes, il peut être aisément décollé du support 400. Le moule 500 en PDMS correspond à la réplique de la topographie du support 400. Le moule 500 ainsi fabriqué (figure 6) est déformable sans rupture en extension et en contraction jusqu'à 120% par rapport à sa valeur initiale. Il résiste aussi à des températures voisines de 200°C pendant une dizaine d'heures.

Dans cet exemple de réalisation, l'imprécision du positionnement des éléments unitaires est de l'ordre de 50µm. Cette imprécision est exclusivement liée à la technique de fabrication du support 400 fabriqué par fraisage mécanique. Il est possible d'améliorer cette précision d'alignement en fabricant des moules d'assemblage 500 avec une marge de l'ordre de 10µm en utilisant par exemple les techniques de gravure chimique ou les techniques d'abrasion par laser.

L'assemblage tridimensionnel de structures élémentaires, comprenant les microbatteries au lithium, dont les dimensions géométriques externes sont de 4mmx4mm est ensuite réalisé en parallèle.

A titre d'exemple, un volume de 1ml de la colle Epo-Tek H20E (Epoxy Technology) est étalé sur les contacts électriques 210 en utilisant une technique de dispense avec des seringues calibrées. Cette colle a une viscosité de 3,2 Pa.S. Elle est à base d'époxy et contient des inclusions métalliques en argent dont le diamètre moyen est inférieur à 45µm. Il s'agit d'une colle bi-composante dont le rapport massif de mélange est 1:1.

Après la dispense de la colle, on réalise un traitement thermique à une température de 150°C pendant 10 minutes sous air. Un appui mécanique (masse de 10g) est appliqué pendant le recuit thermique de la colle conductrice pour un meilleur étalement des points de colle.

La colle électriquement isolante utilisée pour remplir l'espace inter-batteries est la colle Epo-Tek 301-2 commercialisée par Epoxy Technology. Un mélange massique des deux composantes de cette référence selon les proportions 100 pour 35 permet d'avoir des produits dotés d'une viscosité de 0,3 Pa.S. Le profil de réticulation thermique de cette référence nécessite une température de 80°C pour une durée de 3 heures sous air.

Après démoulage, l'assemblage comprenant 5 microbatteries est observé par microscopie en tomographie (figure 12). Les différentes interfaces entre les 5 microbatteries unitaires sont clairement visibles.

## Revendications

1. Moule d'assemblage (500), réutilisable, pour fabriquer un dispositif tridimensionnel comprenant plusieurs composants microélectroniques (300) empilés verticalement, le moule d'assemblage (500) comprenant une cavité principale (501), formée d'un fond et d'une paroi latérale,
la cavité principale (501) étant configurée pour recevoir au moins une première structure élémentaire et une deuxième structure élémentaire empilées,
chaque structure élémentaire comprenant un substrat (200) fragile recouvert par un composant microélectronique (300) et par des contacts électriques (210) disposés sur le bord du substrat (200),
le moule d'assemblage (500) étant en un matériau déformable pouvant subir une déformation réversible de 10 à 1000% par rapport à sa forme initiale, préférentiellement de 50 à 200% par rapport à sa forme initiale,
le moule d'assemblage (500) comprenant en outre un dégagement (510) positionné le long de la paroi latérale de la cavité principale (501) pour faciliter la manipulation de la première structure élémentaire et/ou de la deuxième structure élémentaire et/ou pour injecter un élément le long de la cavité principale (501).

2. Moule d'assemblage selon la revendication 1, **caractérisé en ce qu'**il est en un matériau polymère, de préférence, du polysiloxane.

3. Moule d'assemblage selon l'une des revendications précédentes, **caractérisé en ce que** le fond de la cavité principale (501) a une forme carrée.

4. Moule d'assemblage selon l'une quelconque des revendications précédentes, **caractérisé en ce que** le moule d'assemblage (500) comprend une cavité additionnelle (520), formant un réservoir, en connexion fluidique (521) avec la cavité principale (501).

5. Procédé de fabrication d'un dispositif tridimensionnel comprenant plusieurs composants microélectroniques (300) empilés verticalement, le procédé comprenant les étapes suivantes :
a) fournir une première structure élémentaire et une deuxième structure élémentaire, chaque structure élémentaire comprenant un substrat (200) fragile ayant une première face principale (201) et une deuxième face principale (202), la première face principale (201) du substrat (200) étant recouverte par un composant microélectronique (300), et par des contacts électriques (210), disposés sur le bord du substrat (200), et électriquement connectés au composant microélectronique,
b) fournir un moule d'assemblage (500) tel que défini dans l'une quelconque des revendications 1 à 4, comprenant une cavité principale (501), formée d'un fond et d'une paroi latérale, et configurée pour recevoir au moins deux structures élémentaires, le moule d'assemblage (500) étant en un matériau déformable pouvant subir une déformation réversible de 10 à 1000% par rapport à sa forme initiale, préférentiellement de 50 à 200% par rapport à sa forme initiale,
c) disposer la première structure élémentaire dans la cavité principale (501) du moule d'assemblage (500),
d) former une couche de colle électriquement isolante (330) sur la première structure élémentaire,
e) disposer la deuxième structure élémentaire dans la cavité principale (501) du moule d'assemblage (500),
f) connecter électriquement les contacts électriques (210) de la première structure élémentaire et les contacts électriques (210) de la deuxième structure élémentaire,
moyennant quoi on forme un dispositif tridimensionnel comprenant plusieurs composants microélectroniques (300) empilés verticalement.

6. Procédé selon la revendication précédente, **caractérisé en ce que** les étapes d), e) et f) sont réalisées dans l'ordre suivant : e), d) puis f), ou e), f) puis d).

7. Procédé selon l'une des revendications 5 et 6, **caractérisé en ce que** le moule d'assemblage (500) comprend une cavité additionnelle (520), formant un réservoir, en connexion fluidique (521) avec la cavité principale (501), et **en ce que** la couche de colle électriquement isolante (330) est formée en injectant entre les structures élémentaires la colle électriquement isolante à partir de la cavité additionnelle (520).

8. Procédé selon l'une quelconque des revendications 5 à 7, **caractérisé en ce que** le moule d'assemblage (500) comprend un dégagement (510), positionné le long de la paroi latérale de la cavité principale (501), au niveau des contacts électriques (210) des structures élémentaires et **en ce que** l'étape f) est réalisée en remplissant le dégagement d'un élément électriquement conducteur (320) moyennant quoi on connecte électriquement les contacts électriques (210) des deux structures élémentaires.
